# EUROPEAN PATENT APPLICATION

(11) **EP 4 435 875 A1**
(43) Date of publication of application: **25.09.2024**
(21) Application number: 22896155.3
(22) Date of filing: 21.11.2022
(51) Int. Cl.: H01L 33/50, H01L 33/62, H01L 27/12

(54) **MULTI-COLOR ELEMENT**

(30) Priority: 19.11.2021 US 202163281130 P; 07.02.2022 US 202263307508 P; 17.11.2022 US 202217988860
(71) Applicant: Seoul Viosys Co., Ltd., Ansan-si, Gyeonggi-do 15429 (KR)
(72) Inventor: YOO, Hong Jae, Ansan-Si Gyeonggi-do 15429 (KR); CHO, Sung Ryong, Ansan-Si Gyeonggi-do 15429 (KR)
(74) Representative: Stolmár & Partner Patentanwälte PartG mbB
(86) International application number: PCT/KR2022/018372
(87) International publication number: WO 2023/090958

(57) **Abstract**

A multi-color element according to one embodiment of the present disclosure comprises: a base; a first conductive type semiconductor area arranged on the base; a control unit arranged on the first conductive type semiconductor area; a colored area formed on the control unit; and a second conductive type semiconductor area arranged on the colored area, wherein the control unit alleviates strain within the colored area, the colored area includes a first colored part and a second colored part, and the first colored part includes a colored material having a composition differing from that of the second colored part.

## Description

### [Technical Field]

The present disclosure relates to a Di-chromic device.

### [Background Art]

Implementation of various colors is used in various fields in daily life, and for example, various colors are implemented in various fields such as lighting, automobiles, light therapy, and displays.

In general, since a light emitting diode emits light having a single narrow full width at half maximum, it emits light of a single color in a visible light region. In order to implement various colors, a plurality of light emitting diodes having different peak wavelengths is used, or wavelength conversion materials such as phosphors are used together with the light emitting diodes.

However, in order to implement various colors using the plurality of light emitting diodes, it is necessary to manufacture light emitting diodes having different peak wavelengths using different materials and arrange them adjacent to one another. Accordingly, it is complicated to manufacture a module for implementing various colors.

Meanwhile, when using the phosphor together with the light emitting diode, it is not easy to arrange a suitable phosphor on the light emitting diode, and furthermore, it is necessary to solve drawbacks such as deterioration of the phosphor or the deterioration of a molding member supporting the phosphor. Moreover, efficiency reduction due to the use of the phosphor cannot be avoided. Furthermore, since the phosphor is disposed on the light emitting diode, an increase in size is inevitable.

### [DISCLOSURE]

### [Technical Problem]

Embodiments according to the present disclosure may provide a module that is configured to be stably driven, and a di-chromic device that is configured to implement various colors.

Embodiments according to the present disclosure provide a di-chromic device that is configured to implement various colors without a phosphor.

Embodiments according to the present disclosure provide a phosphorless di-chromatic device having optimal efficiency at current densities used in actual applications.

### [Technical Solution]

A di-chromic device according to an embodiment of the present disclosure includes a base, a first conductivity type semiconductor region disposed on the base, a control portion disposed on the first conductivity type semiconductor region, a color region formed on the control portion, and a second conductivity type semiconductor region disposed on the color region, in which the control portion is configured to relieve strain in the color region, the color region includes a first color portion and a second color portion, and the first color portion includes a color material having a composition different from that of the second color portion.

The first color portion may generate blue light, and the second color portion may generate green or yellow light. Furthermore, the di-chromic device may implement white light by a combination of blue light from the first color portion and green or yellow light from the second color portion.

In an embodiment, each of the first color portion and the second color portion may include a plurality of sub-color portions, and the number of sub-color portions in the first color portion may be greater than the number of sub-color portions in the second color portion.

The number of sub-color portions in the first color portion may be 2 to 7 times of the number of sub-color portions in the second color portion.

Furthermore, the di-chromic device may emit white light under a current density within a range of about 1.75A/cm² or more and less than about 35A/cm².

In another embodiment, each of the first color portion and the second color portion may include a plurality of sub-color portions, and the number of sub-color portions in the second color portion may be equal to or greater than the number of sub-color portions in the first color portion.

The number of sub-color portions in the second color portion may be 1 to 4 times of the number of sub-color portions in the first color portion.

Furthermore, the di-chromic device may emit white light under a current density within a range of about 35A/cm² or more and about 140A/cm² or less.

The di-chromic device may further include pad electrodes electrically connected to the first conductivity type semiconductor region and the second conductivity type semiconductor region, respectively.

The color region may be formed of a nitride semiconductor, and may emit light having peak wavelengths equal to or greater than the number of the pad electrodes.

The di-chromic device may further include bump electrodes electrically connected to the pad electrodes, respectively.

The di-chromic device may further include a tunnel barrier layer between the first color portion and the second color portion.

The tunnel barrier layer may include an AlGaN layer or DBR.

Each of the first color portion and the second color portion may include a plurality of barrier layers and a plurality of well layers disposed between the barrier layers, the well layers of the first color portion may have a band gap wider than the well layers of the second color portion, and the first color portion may be closer to the first conductivity type semiconductor region than the second color portion.

Among the barrier layers of the first color portion, a first barrier layer closest to the first conductivity type semiconductor region may include a GaN layer doped with Si, and remaining barrier layers may not include an intentionally doped layer.

Furthermore, among the barrier layers of the first color portion, the remaining barrier layers may be formed of an AlGaN layer.

Among the barrier layers of the second color portion, barrier layers excluding a last barrier layer may include a GaN layer doped with Si, and the last barrier layer may not include an intentionally doped layer.

A first barrier layer of the second color portion may be formed of a GaN layer, and the barrier layers disposed between the well layers of the second color portion may include an AlGaN capping layer, an Al(Ga)N layer having a band gap wider than the AlGaN capping layer, and a GaN layer.

The control portion may include a holder generating a spot. Furthermore, the color region may include an extension extending toward the spot in a V shape.

### [Description of Drawings]

FIG. 1 is a schematic cross-sectional view illustrating a color device according to an embodiment of the present disclosure.
FIG. 2 is an enlarged cross-sectional view of a portion of FIG. 1.
FIG. 3 is a schematic cross-sectional view illustrating a color device according to an embodiment of the present disclosure.
FIG. 4 is a schematic cross-sectional view illustrating a color device according to an embodiment of the present disclosure.
FIG. 5 is a schematic cross-sectional view illustrating a color device according to an embodiment of the present disclosure.
FIG. 6 is a schematic cross-sectional view illustrating a color device according to an embodiment of the present disclosure.
FIG. 7 is a schematic cross-sectional view illustrating a color device according to an embodiment of the present disclosure.
FIG. 8A is a schematic band diagram illustrating a color device according to an embodiment of the present disclosure.
FIG. 8B is a band diagram showing an enlarged color region of FIG. 8A.
FIG. 9A is a schematic band diagram illustrating a color device according to an embodiment of the present disclosure.
FIG. 9B is a band diagram showing an enlarged color region of FIG. 9A.
FIG. 10A is a schematic band diagram illustrating a color device according to an embodiment of the present disclosure.
FIG. 10B is a band diagram showing an enlarged color region of FIG. 10A.
FIG. 11A is a schematic band diagram illustrating a color device according to an embodiment of the present disclosure; FIG. 11B is a band diagram showing enlarged portions of a first color region 60b and a second color region 60g.
FIG. 12 is a schematic cross-sectional view illustrating a di-chromic device according to an embodiment of the present disclosure.
FIG. 13 is a schematic cross-sectional view illustrating a module according to an embodiment of the present disclosure.
FIG. 14 is a schematic cross-sectional view illustrating a color device according to another embodiment of the present disclosure.
FIG. 15 is a schematic cross-sectional view illustrating a color device according to another embodiment of the present disclosure.
FIG. 16 is a graph showing a spectrum of a di-chromic device according to an embodiment of the present disclosure.
FIG. 17 is a graph showing a spectrum of a di-chromic device according to an embodiment of the present disclosure.
FIG. 18A is a perspective view illustrating a light emitting diode package to which a light emitting diode according to an embodiment of the present disclosure is applied.
FIG. 18B is a plan view of FIG. 18A.
FIG. 18C is a cross-sectional view taken along line I-I' of FIG. 18B.
FIG. 19 is a cross-sectional view illustrating a display apparatus to which a color device according to an embodiment of the present disclosure is applied.
FIG. 20 is a cross-sectional view illustrating a display apparatus to which a color device according to another embodiment of the present disclosure is applied.
FIG. 21 is a cross-sectional view illustrating a lighting apparatus to which a color device according to another embodiment of the present disclosure is applied.
FIGs. 22A, 22B, and 22C are a schematic cross-sectional view, a plan view, and a circuit diagram illustrating a display apparatus to which a color device according to another embodiment of the present disclosure is applied, respectively.

### [Detailed Description of the Illustrated Embodiments]

Hereinafter, embodiments will be described in detail with reference to the accompanying drawings. The following embodiments are provided by way of example so as to fully convey the spirit of the present disclosure to those skilled in the art to which the present disclosure pertains. Accordingly, the inventive concepts are not limited to the embodiments disclosed herein and can also be implemented in different forms. In the drawings, widths, lengths, thicknesses, and the like of elements can be exaggerated for clarity and descriptive purposes. When an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

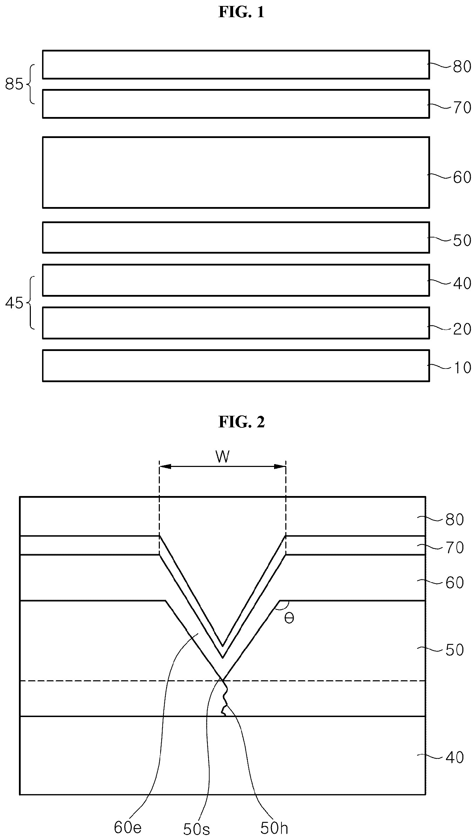

FIG. 1 is a schematic cross-sectional view illustrating a color device according to an embodiment of the present disclosure.

Referring to FIG. 1, the color device according to this embodiment may include a base 10, a buffer layer 20, a first conductivity type semiconductor layer 40, a control portion 50, a color region 60, a resistor 70, and a second conductivity type semiconductor layer 80.

The base 10 may be a printed circuit board, a sapphire substrate, a silicon substrate, a GaN substrate, polyimide, an epoxy molding compound (EMC), or the like. The base 10 may be disposed on a path through which light emitted from the color region 60 passes or transmits. Light may pass through the base 10 and be emitted to the outside of the color device.

The base 10 may have a concavo-convex shape on its surface, and light may be scattered using the concavo-convex shape. When the color region 60 emits light having a plurality of peak wavelengths, light having different peak wavelengths may be mixed in the base 10. That is, the base 10 may serve as a mixing zone of light.

The buffer layer 20 may be formed of, for example, an undoped AlGaN layer as a low-temperature buffer layer for growing a gallium nitride-based semiconductor layer on a heterogeneous substrate, for example, a nucleation layer. A high-temperature buffer layer, for example, an undoped GaN layer, may be additionally formed on the buffer layer 20.

The first conductivity type semiconductor layer 40 may serve as a contact layer for supplying electricity to the color device. The first conductivity type semiconductor layer 40 may include a III-V material such as AlxIn(y)Ga(1-x-y)N (x, y >= 0) or GaAs or GaInP, and may be doped with a dopant such as Si. The buffer layer 20 and the first conductivity type semiconductor layer 40 may constitute a first conductivity type semiconductor region 45.

The color region 60 may be formed on the first conductivity type semiconductor layer 40. The color region 60 may include a III-V material such as AlxIn(y)Ga(1-x-y)N (x, y >= 0) or GaAs, GaInP. The color region 60 may have a structure in which a plurality of color portions emitting light of different colors is vertically stacked with one another. The plurality of color portions may include a first color portion and a second color portion. Each of the color portions may have different types of color materials that determine a peak wavelength, CIE, or CRI of emitted light, or may have different amounts of color materials. For example, the first color portion and the second color portion may have different peak wavelengths, and the color material of the first color portion may emit light of a shorter wavelength than the color material of the second color portion. For example, the first color portion may emit blue light, and the second color portion may emit green or yellow light.

In an embodiment, the first color portion emitting light having a relatively shorter peak wavelength may be disposed closer to the first conductivity type semiconductor layer 40 than the second color portion, and the second color portion emitting light having a relatively longer peak wavelength may be disposed closer to the second conductivity type semiconductor layer 80 than the first color portion. However, the inventive concepts are not limited thereto, and positions of the first color portion and the second color portion may be changed according to a device structure.

The resistor 70 may be formed on the color region 60. The resistor 70 serves as a resistor in a flow of current, and may function as a barrier so as to prevent electrons injected from the first conductivity type semiconductor layer 40 from flowing into the second conductivity type semiconductor layer 80. The resistor 70 may include a III-V material such as AlxIn(y)Ga(1-x-y)N (x, y >= 0) or GaAs or GaInP, and may have an energy band gap wider than those of the first and second conductivity type semiconductor layers 40 and 80. For example, the energy band gap of at least one layer of the resistor 70 may be wider than the energy band gap of at least one layer of the first and second conductivity type semiconductor layers 40 and 80 by 0.9 eV or more. The resistor 70 may be formed of a single layer or a plurality of layers. When formed of the plurality of layers, the resistor 70 may include a plurality of layers having different Al contents or band gap energies, and in this case, a layer having a relatively high Al content or a layer having a relatively wide band gap energy may be disposed closer to the color region 60. A difference in Al contents between the layer with a relatively high Al content and a layer with a relatively low Al content may be within 10%, or a difference in band gap energies may be within 0.6 eV. In another embodiment, a profile of the Al content of the resistor portion 70 may be substantially similar to a profile of an In content of the resistor portion 70. That is, the In content may be relatively high where the Al content is relatively high, and the In content may be relatively low where the Al content is relatively low. However, the inventive concepts are not necessarily limited thereto, and the profile of the Al content and the profile of the In content may be different.

The control portion 50 may be formed between the first conductivity type semiconductor layer 40 and the color region 60. As shown in FIG. 2, the control portion 50 may include a holder 50h generating a spot 50s. The control portion 50 may include a material such as InGaN, GaN, InGaAs, GaAs, or the like, and a portion of the color region 60 may extend toward the spot 50s by the spot 50s formed on the holder 50h to form an extension 60e. The holder 50h may be formed by forming a holding layer using a TMGa material. The holder 50h may have a height of about 1000Å to about 2500Å. A plurality of holders 50h may be formed in the control portion 50, and the plurality of holders 50h may be laterally spaced apart.

The control portion 50 may include an expansion portion at a boundary portion with the color region 60. The expansion portion assists to form a larger extension 60e of the color region 60 extending in a direction of the spot 50s of the holder 50h. The extension 60e may be formed in a V shape, and may include a color portion. The expansion portion may be formed of a single layer or a plurality of layers, and may include, for example, a superlattice structure. A material for the expansion portion may include a III-V material such as AlxIn(1-x)GaN (x, y >= 0), GaAs, or GaInP, and may include a dopant such as Si. In a case of including the dopant, a doping concentration may be in a concentration range of 1E17 to 5E18/cm³. The expansion portion may be formed within a thickness range of 1000Å to 2500Å. The expansion portion may have a band gap corresponding to an energy of light having a wavelength of 405nm or less. The superlattice structure for the expansion portion may have, for example, a structure in which InGaN/GaN are repeatedly stacked. However, the inventive concepts are not limited thereto, and may include at least two or more layers having different doping concentrations from each other, or at least two or more layers having different band gap energies from each other.

The control portion 50 may further include an intermediate layer between the holder 50h and the expansion portion. The intermediate layer may be formed of a plurality of layers, may include a III-V material such as AlxIn(y)Ga(1-x-y)N (x, y >= 0) or GaAs and GaInP, and each of the plurality of layers may have a thickness of about 10Å to 150Å.

The second conductivity type semiconductor layer 80 may be formed on the resistor 70. The second conductivity type semiconductor layer 80 may have a polarity opposite to that of the first conductivity type semiconductor layer 40, and may include, for example, a material such as Mg, B, or the like. The resistor 70 and the second conductivity type semiconductor layer 80 may constitute a first conductivity type semiconductor region 85. The material such as Mg, B, or the like of the second conductivity type semiconductor layer 80 may have an inclined profile, and may have a left-right asymmetrical profile with respect to a peak point having a highest content of the material. Preferably, a slope of a profile in a direction closer to the color region 60 with respect to the peak point may be relatively gentler than a slope of a profile disposed opposite to the peak point.

Although not shown, a bridge region having a same polarity as that of the first conductivity type semiconductor layer 40 may be further formed on the second conductivity type semiconductor layer 80. A color region emitting light of a different color may be further formed on the color device of the embodiment via the bridge region.

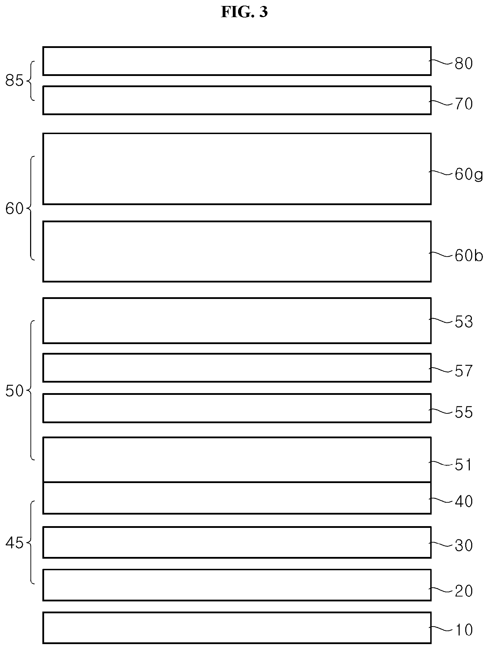

Hereinafter, a specific example of the color device will be described in more detail with reference to FIG. 3. FIG. 3 is a schematic cross-sectional view illustrating a color device according to an embodiment of the present disclosure.

Referring to FIG. 3, the color device according to this embodiment, as described with reference to FIG. 1, may include a base 10, a first conductivity type semiconductor region 45, a control portion 50, a color region 60, and a second conductivity type semiconductor region 85.

Since the base 10 has been described with reference to FIG. 1, a detailed description thereof will be omitted to avoid redundancy. The first conductivity type semiconductor region 45 may include a buffer layer 20, an undoped GaN layer 30, and a first conductivity type semiconductor layer 40. The first conductivity type semiconductor region 45 of this embodiment is same as the first conductivity type semiconductor region 45 described with reference to FIG. 1, except that the undoped GaN layer 30 is clearly shown in the drawing, and a detailed description thereof is omitted.

The control portion 50 may be formed of a plurality of layers. As shown in FIG. 3, the control portion 50 may include a first V-pit generation layer(VGL, 51), a first intermediate layer 55, a second intermediate layer 57, and a second VGL 53. Each of the layers of the control portion 50 may be formed of AlxInyGa(1-x-y)N (x, y >= 0) or GaAs or GaInP, and each of the first and second intermediate layers may include layers having different band gap energies from each other.

As shown in FIG. 3, among the layers of the control portion 50, the first VGL 51 may be disposed closest to the first conductivity type semiconductor layer 40, and the second VGL 53 may be closest to the second conductivity type semiconductor layer 80. The first intermediate layer 55 and the second intermediate layer 57 may be disposed between the first VGL 51 and the second VGL 53. Additional layers may be further included between these layers, but the inventive concepts are not necessarily limited thereto.

The first VGL 51 may be grown at a temperature lower than a growth temperature of the first conductivity type semiconductor layer 40, for example, 900°C. or less, and may include a GaN layer. The first VGL 51 may be formed using a TMGa source so as to increase a growth rate, which may adjust a size and a density of a holder, for example, a V-pit. The first VGL 51 may be formed to have a thickness within a range of about 1000Å to about 2500Å. The first VGL 51 may have a larger thickness than that of the second VGL 53, and a thickness difference may be preferable within 30%. A sum of the thicknesses of the first VGL 51 and the second VGL 53 may be greater than a sum of the thicknesses of the color region 60. Alternatively, the sum of the thicknesses of the first VGL 51 and the second VGL 53 may be greater than a sum of thicknesses of a resistor 70 and the second conductivity type semiconductor layer 80. Alternatively, the sum of the thicknesses of the first VGL 51 and the second VGL 53 may be greater than a thickness from an interface between the second VGL 51 and an adjacent layer in a direction of the color region 60 to an interface where the second conductivity type semiconductor layer 80 is electrically connected to a conductive electrode. In this case, the difference in thicknesses may be 1.5 times or more. A doping concentration of the first conductivity type semiconductor layer 40 may be 7 times greater than that of at least one of the first VGL 51 and the second VGL 53.

The first intermediate layer 55 or the second intermediate layer 57 is a layer added so as to substantially control strain, and may be formed of AlN, AlxGa(1-x)N, or GaN. Each of the first and second intermediate layers 55 and 57 may have a thickness of about 10Å to about 150Å. The first intermediate layer 55 or the second intermediate layer 57 may include an n-type dopant. A doping concentration of the first intermediate layer 55 or the second intermediate layer 57 may be lower than that of the first conductivity type semiconductor layer 40, and higher than that of the second VGL 53.

The second VGL 53 may be a single layer or a plurality of layers, and may have a superlattice structure, but the inventive concepts are not necessarily limited thereto. The second VGL 53 may be formed of InGaN/GaN or GaN or InGaN, and for example, it may be InGaN/GaN containing In so as to have an energy band gap corresponding to an energy of a wavelength of 405nm or less. In this case, the second VGL 53 may grow relatively slowly along a V-pit structure formed in the first VGL 51 by using a TEGa source as a Ga source. The second VGL 53 may be grown at a temperature lower than the growth temperature of the first conductivity type semiconductor layer 40, for example, 900°C. or lower. The second VGL 53 may be formed to have a thickness of about 1000Å to about 2500Å, and may be doped with impurities. For example, a doping concentration of silicon doped into the second VGL 53 may be 1E17 to 5E18/cm³.

When analyzed with SIMS (secondary ion mass spectrometry), a material having a largest standard atomic weight (relative atomic mass or standard atomic weight) or a material having a largest atomic number among group 3 elements included in the light emitting device may be detected in the second VGL 53. A detection amount of the material having the largest standard atomic weight or atomic number may gradually decrease toward a direction of the first conductivity type semiconductor layer 40. When analyzed with SIMS, a thickness of a gradually decreasing region of the material having the largest standard atomic weight or atomic number may be detected as a larger thickness than a thickness of the color region 60. Accordingly, since the region in which the material having the largest standard atomic weight or atomic number is detected is formed wide in a region between the first conductivity type semiconductor layer 40 and the second conductivity type semiconductor layer 80, it makes it possible to effectively generate white light in the color region 60.

The color region 60 may include a plurality of color portions 60b and 60g. For example, a first color portion 60b may emit blue light, and a second color portion 60g may emit green or yellow light. The first and second color portions 60b and 60g may have a single or multiple quantum well structure, and may include an InGaN, InAlGaN, GaInP, or GaInAlP well layer.

A V-shaped extension (60e in FIG. 3) is formed by the control portion 50, and thus, strain relief of the color region 60 occurs. Accordingly, a greater amount of In may flow into the color region 60, and thus, a radiation efficiency of the plurality of color portions may be improved in a single LED structure, and white light may be implemented without a phosphor.

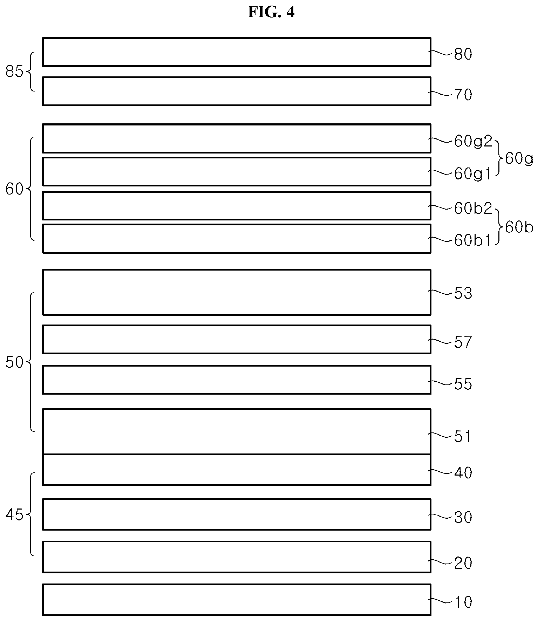

FIG. 4 is a schematic cross-sectional view illustrating a color device according to another embodiment of the present disclosure.

Referring to FIG. 4, the color device according to this embodiment is generally similar to the color device described with reference to FIG. 3, except that the color portions in the color region 60 include sub-color portions. That is, the first color portion 60b may include first and second sub-color portions 60b1 and 60b2, and the second color portion 60g may include first and second sub-color portions 60g1 and 60g2. Each of the first and second sub-color portions 60b1 and 60b2 may have a single quantum well structure emitting light in a blue region, and each of the first and second sub-color portions 60g1 and 60g2 may have a single quantum well structure emitting light in a green or yellow region.

The second sub-color portion 60b2 may emit light having a longer wavelength than that of the first sub-color portion 60b1. Specifically, the first sub-color portion 60b1 may emit light having a peak wavelength within a range of 410nm to 455nm, and the second sub-color portion 60b2 may emit light having a peak wavelength within a range of 455nm to 495nm. The second sub-color portion 60g2 may emit light having a longer wavelength than that of the first sub-color portion 60g1. For example, the first sub-color portion 60g1 may emit light having a peak wavelength within a range of 505nm to 550nm, and the second sub-color portion 60g2 may emit light having a peak wavelength within a range of 550nm to 605nm. In an embodiment, a gap between a peak wavelength of light emitted from the first sub-color portion 60b1 and a peak wavelength of light emitted from the second sub-color portion 60b2 may be 100nm or less, and a gap between the peak wavelength of light emitted from the first sub-colored portion 60g1 and the peak wavelength of light emitted from the second sub-colored portion 60g2 may be 100nm or less. A minimum gap between the peak wavelength of light emitted from the first color portion 60b and the peak wavelength of light emitted from the second color portion 60g may be 200nm or less. For example, the gap between the peak wavelength of light emitted from the second sub-color portion 60b2 and the peak wavelength of light emitted from the first sub-color portion 60g1 may be 200nm or less.

Visibility of light emitted from the color device may be improved by controlling the peak wavelengths of light emitted from the first and second sub-color portions 60b1 and 60b2 and the first and second sub-color portions 60g1 and 60g2.

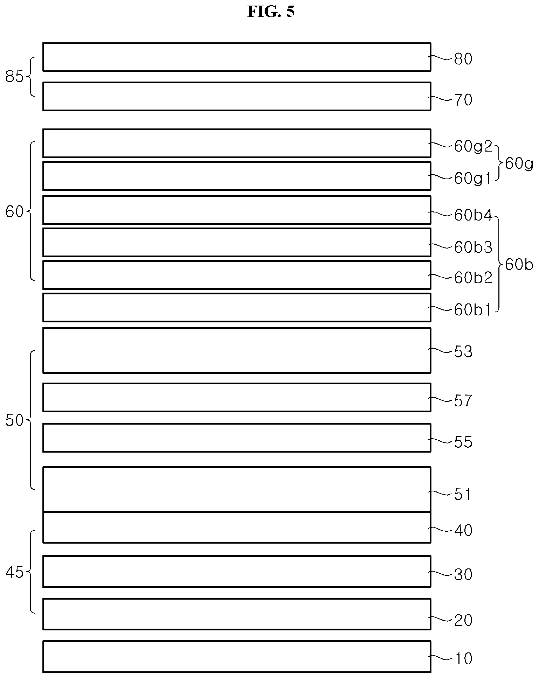

FIG. 5 is a schematic cross-sectional view illustrating a color device according to another embodiment of the present disclosure.

Referring to FIG. 5, the color device according to this embodiment is substantially similar to the color device described with reference to FIG. 4, except that the number of sub-color portions 60b1 through 60b4 emitting blue light is more than the number of sub-color portions 60g1 and 60g emitting green light or yellow light. The sub-color portions 60b1 through 60b4 may emit light having substantially similar peak wavelengths, but may emit light having different peak wavelengths within a blue region. The sub-color portions 60g1 and 60g2 may also emit light having substantially similar peak wavelengths, but may also emit light having different peak wavelengths within a green to yellow region.

There is a difference in luminous efficiency between the color portion 60b and the color portion 60g depending on a current density J applied to the color device. By arranging more sub-color portions 60b1 through 60b4 than the number of sub-color portions 60g1 and 60g2, white light with maximum efficiency may be implemented at a low current density within a range of 1.75A/cm² to 35A/cm².

Specifically, there may be two blue sub-color portions per one green or yellow sub-color portion (B/G ratio: 2/1), three blue sub-color portions per one green or yellow sub-color portion (B/G ratio: 3/1), four blue sub-color portions per one green or yellow sub-color portion (B/G ratio: 4/1), five blue sub-color portions per one green or yellow sub-color portion (B/G ratio: 5/1), six blue sub-color portions per one green or yellow sub-color portion (B/G ratio: 6/1), or seven blue sub-color portions per one green or yellow sub-color portion (B/G ratio) ratio: 7/1). In particular, the number of blue sub-color portions per one green or yellow sub-color portion may be 4 to 7, and within this range, white light having a favorable radiation efficiency may be implemented. A total number of blue sub-color portions and green or yellow sub-color portions may be 3 or more and 16 or less.

For this configuration, the first color portion 60b emitting blue light is disposed close to the first conductivity type semiconductor layer 40, and the second color portion 60g emitting green or yellow light is disposed close to the second conductivity type semiconductor layer 80.

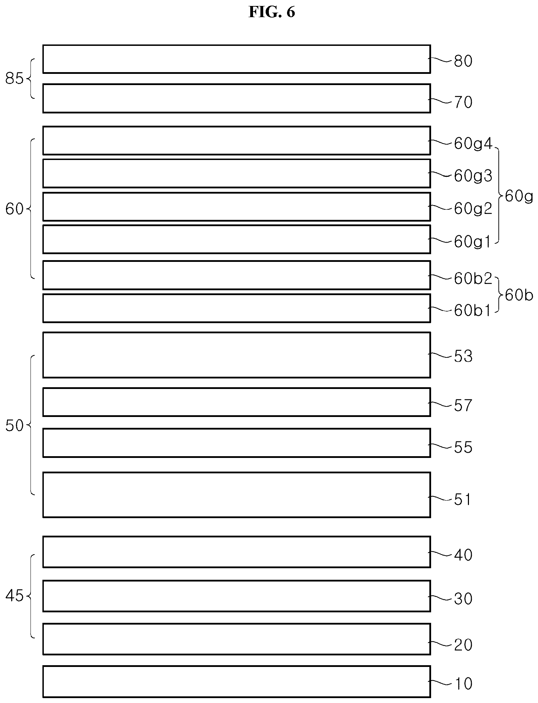

FIG. 6 is a schematic cross-sectional view illustrating a color device according to another embodiment of the present disclosure.

Referring to FIG. 6, the color device according to this embodiment is substantially similar to the color device described with reference to FIG. 4, except that the number of sub-color portions 60b1 and 60b2 emitting blue light is less than the number of sub-color portions 60g1 through 60g4 emitting green light or yellow light. That is, the number of sub-color portions 60g1 through 60g4 is greater than the number of sub-color portions 60b1 and 60b2.

There is a difference in luminous efficiency between the color portion 60b and the color portion 60g depending on a current density J applied to the color device. By arranging the number of sub-color portions 60g1 through 60g4 greater than or equal to the number of sub-color portions 60b1 and 60b2, white light with maximum efficiency may be implemented at a high current density within a range of 35A/cm² to 140A/cm².

Specifically, there may be one green or yellow sub-color portion per one blue sub-color portion (B/G ratio: 1/1), two green or yellow sub-color portions per one blue sub-color portion (B/G ratio: 1/2), three green or yellow sub-color portions per blue sub-color portion (B/G ratio: 1/3), four green or yellow sub-color portions per blue sub-color portion (B/G ratio: 1/4), five green or yellow sub-color portions per blue sub-color portion (B/G ratio: 1/5), six green or yellow sub-color portions per blue sub-color portion (B/G ratio: 1/6), or seven green or yellow sub-color portions per blue sub-color portion (B/G ratio: 1/7). In particular, the number of green or yellow sub-color portions per one blue sub-color portion may be 1 to 4, and within this range, white light having a favorable radiation efficiency may be implemented. A total number of blue sub-color portions and green or yellow sub-color portions may be 2 or more and 15 or less.

For this configuration, the first color portion 60b emitting blue light is disposed close to the first conductivity type semiconductor layer 40, and the second color portion 60g emitting green or yellow light is disposed close to the second conductivity type semiconductor layer 80.

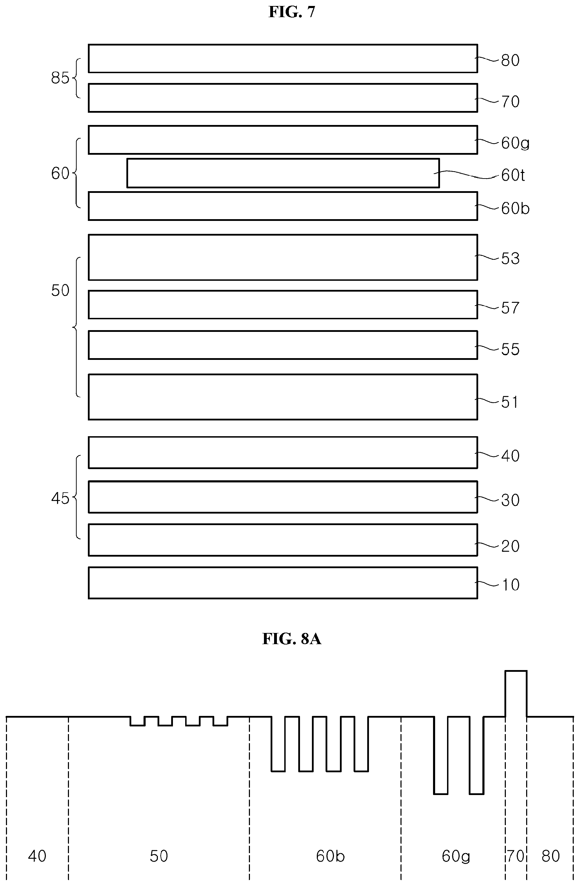

FIG. 7 is a schematic cross-sectional view illustrating a color device according to another embodiment of the present disclosure.

Referring to FIG. 7, the color device according to this embodiment is substantially similar to the color device described with reference to FIG. 3, except that a tunnel barrier layer 60t is disposed between a first color portion 60b and a second color portion 60g.

The tunnel barrier layer 60t is disposed between the color portions 60b and 60g having different band gaps and emitting light of different peak wavelengths to alleviate light interference between the color portions. The tunnel barrier layer 60t may be applied to both the color device suitable for the low current density described with reference to FIG. 5 and the color device suitable for the high current density described with reference to FIG. 6. By disposing the tunnel barrier layer 60t, white light with high efficiency may be implemented by combining a luminous intensity of blue light and a luminous intensity of green light or yellow light optimized at the low current density of less than 35A/cm² and the high current density of 35A/cm² or more, electroluminescence intensities of the color portions 60b and 60g may be adjusted, respectively, and accordingly, a visibility of the color devices may be improved.

Specifically, the tunnel barrier layer 60t may be disposed between the first color portion 60b and the second color portion 60g. The first color portion 60b is disposed close to the first conductivity type semiconductor layer 40, and the second color portion 60g is disposed close to the second conductivity type semiconductor layer 80. The tunnel barrier layer 60t may include an AlGaN layer or a material layer capable of serving as a color filter, such as DBR. For example, a radiation efficiency of the color device may be increased by preventing shorter wavelength light emitted from the first color portion 60b from affecting the second color portion 60g.

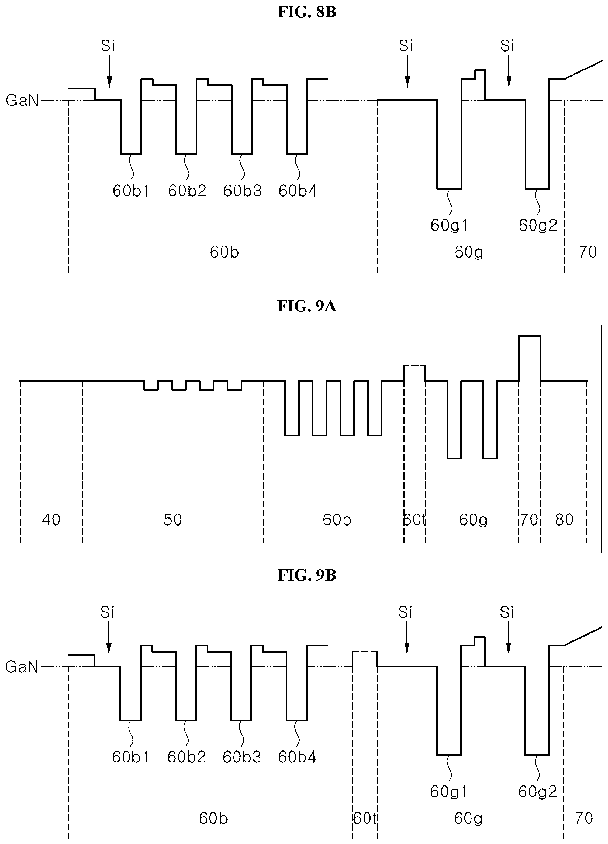

FIG. 8A is a schematic band diagram illustrating a color device according to an embodiment of the present disclosure, and FIG. 8B is a band diagram showing enlarged portions of a first color portion 60b and a second color portion 60g. In FIGs. 8A and 8B, only conduction bands are shown, and in FIG. 8B, a position of the conduction band of each layer is shown with respect to a conduction band of GaN.

Referring to FIGs. 8A and 8B, the color device according to this embodiment implements white light with high efficiency through a combination of blue luminous intensity and green luminous intensity optimized under a low current density, for example, a current density in a range of 1.75A/cm² to 35A/cm². Each of a well layer and a barrier layer of a color region including the first color portion 60b and a second color portion 60g is configured such that light emitted from the first color portion 60b and the second color portion 60g can be combined with high efficiency. Specifically, the first color portion 60b emitting blue light includes a plurality of sub-color portions 60b1, 60b2, 60b3, and 60b4, and the second color portion 60g emitting green or yellow light includes a plurality of sub-color portions 60g1 and 60g2.

In the first color portion 60b, the well layers are disposed between the barrier layers, and the well layers correspond to the sub-color portions 60b1, 60b2, 60b3, and 60b4, respectively. Specifically, as shown in FIG. 8B, in the first color portion 60b, four well layers may be disposed between a first barrier layer and a last barrier layer, and intermediate barrier layers may be disposed between the well layers. Herein, although the number of well layers of the first color portion is illustrated as four, the inventive concepts are not limited thereto. However, the well layers of the first color portion 60b are disposed in a larger number than that of the well layers of the second color portion 60g. Holes move from a second conductivity type semiconductor layer 80 to the second color portion 60g and the first color portion 60b. However, since holes have low mobility, they are difficult to move from a second conductivity type semiconductor layer 80 to the first color portion 60b under a low current density. Therefore, when the number of well layers of the first color portion 60b is same as the number of well layers of the second color portion 60g, a luminous intensity of blue light becomes lower than a luminous intensity of green light, and thus, it is difficult to implement white light. On the contrary, by increasing the number of well layers of the first color portion 60b, the luminous intensity of blue light may be increased, and white light may be implemented. Furthermore, by adjusting a ratio between the number of well layers of the first color portion 60b and the number of well layers of the second color portion 60g, various white light from warm white to cool white may be implemented.

Meanwhile, the first barrier layer of the first color portion 60b may include a GaN layer, and other barrier layers may include an AlGaN layer. The GaN layer of the first barrier layer of the first color portion 60b may be doped with an n-type impurity, for example, Si, and a doping concentration may be within a range of, for example, 5E18/cm³ to 8E18/cm³. No intentional doping is performed on the other barrier layers. The first barrier layer may also include a hole blocking layer, which may be formed of the AlGaN layer. The hole blocking layer may be disposed at a boundary between a control portion 50 and the first color portion 60b. Meanwhile, the barrier layers disposed between the well layers of the first color portion 60b may be formed of the AlGaN layer. Specifically, each of the barrier layers may include an AlGaN capping layer and a high-temperature AlGaN barrier layer, and the AlGaN capping layer may have a band gap wider than the high-temperature AlGaN barrier layer. The AlGaN capping layer may be made thinner than the high-temperature AlGaN barrier layer. For example, the AlGaN capping layer may be formed to have a thickness of about 1nm and the high-temperature AlGaN barrier layer to have a thickness of about 35Å. The AlGaN capping layer is grown at a temperature lower than that for growing the high-temperature AlGaN barrier layer, and for example, it may be grown at a same temperature as a growth temperature of the well layer.

Meanwhile, the well layers 60b1, 60b2, 60b3, and 60b4 may be formed of InGaN or InAlGaN, and may have a composition that emits light in a blue region. The well layers may have a same composition, but the inventive concepts are not limited thereto, and the well layers may have different band gaps from one another.

The second color portion 60g is shown as having two sub-color portions 60g1 and 60g2 disposed between the first and last barrier layers, but the number of the sub-color portions 60g1 and 60g2 is not limited thereto.

A first barrier layer of the second color portion 60g may be a GaN layer, and a last barrier layer may be an AlGaN layer. In addition, barrier layers disposed between the well layers may include an AlGaN capping layer, an Al(Ga)N layer, and a GaN layer. In the second color portion 60g, GaN layers of remaining barrier layers except for the last barrier layer may be doped with an n-type impurity, for example, Si. A doping concentration of Si doped in each of the barrier layers of the second color portion 60g may be lower than the doping concentration of Si doped in the first barrier layer of the first color portion 60b, and for example, it may be within a range of 5E17/cm³ to 1E18/cm³.

Meanwhile, a thickness of each of the well layers of the second color portion 60g may be substantially similar to a thickness of each of the well layers of the first color portion 60b, but the thickness of each of the barrier layers of the second color portion 60g may be greater than the thickness of each of the barrier layers of the first color portion 60b.

A resistor 70 may be disposed so as to prevent electrons from flowing into the second conductivity type semiconductor layer 80 without recombination. The resistor 70 may be formed of an AlGaN layer, and as shown in FIG. 8B, it may be a grading layer in which a composition of Al gradually increases.

In this embodiment, the second color portion 60g emitting green or yellow light is disposed adjacent to the second conductivity type semiconductor layer, and the first color portion 60g emitting blue light is disposed adjacent to the first conductivity type semiconductor layer. Through this, it is possible to provide a color device having improved visibility.

FIG. 9A is a schematic band diagram illustrating a color device according to another embodiment of the present disclosure, and FIG. 9B is a band diagram showing enlarged portions of a first color portion 60b and a second color portion 60g. In FIGs. 8A and 8B, only conduction bands are shown, and in FIG. 8B, a position of the conduction band of each layer is shown with respect to a conduction band of GaN.

Referring to FIGs. 9A and 9B, the color device according to this embodiment is substantially similar to the color device described with reference to FIGs. 8A and 8B, except that it includes an intermediate barrier layer 60t, that is, a tunnel barrier layer. The intermediate barrier layer 60t may be formed of an AlGaN layer, DBR, or the like. A band gap of the intermediate barrier layer 60t may be narrower than that of the barrier layers of the first and second color portions 60b and 60g, without being limited thereto.

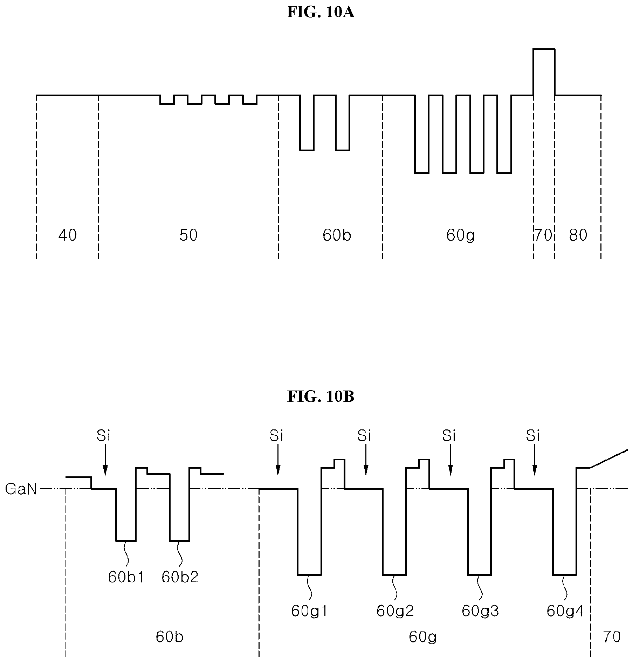

FIG. 10A is a schematic band diagram illustrating a color device according to another embodiment of the present disclosure, and FIG. 10B is a band diagram showing enlarged portions of a first color portion 60b and a second color portion 60g. In FIGs. 10A and 10B, only conduction bands are shown, and in FIG. 10B, a position of the conduction band of each layer is shown with respect to a conduction band of GaN.

Referring to FIGs. 10A and 10B, the color device according to this embodiment implements white light with high efficiency through a combination of blue luminous intensity and green luminous intensity optimized under a high current density, for example, a current density in a range of 35A/cm² to 140A/cm². Each of a well layer and a barrier layer of a color region including the first color portion 60b and the second color portion 60g is configured such that light emitted from the first color portion 60b and the second color portion 60g can be combined with high efficiency. Specifically, the first color portion 60b emitting blue light includes a plurality of sub-color portions 60b1 and 60b2, and the second color portion 60g emitting green or yellow light includes a plurality of sub-color portions 60g1. 60g2, 60g3, and 60g4.

In the first color portion 60b, the well layers are disposed between the barrier layers, and the well layers correspond to the sub-color portions 60b1, and 60b2, respectively. Specifically, as shown in FIG. 10B, in the first color portion 60b, two well layers may be disposed between a first barrier layer and a last barrier layer, and intermediate barrier layers may be disposed between the well layers. Herein, although the number of well layers of the first color portion is illustrated as two, the inventive concepts are not limited thereto. However, the well layers of the first color portion 60b are disposed in a smaller number than that of the well layers of the second color portion 60g. Holes move from a second conductivity type semiconductor layer 80 to the second color portion 60g and the first color portion 60b. However, since holes easily move from the second conductivity type semiconductor layer 80 to the first color portion 60b under the high current density, a recombination rate of electrons and holes in the first color portion 60b increases. Therefore, when the number of well layers of the first color portion 60b is greater than the number of well layers of the second color portion 60g, a luminous intensity of blue light is relatively higher than a luminous intensity of green light, and thus, it is difficult to implement white light. On the contrary, by making the number of well layers of the first color portion 60b equal to or less than the number of well layers of the second color portion 60g, the luminous intensity of blue light may be relatively reduced, and through this, desired white light may be implemented. Furthermore, by adjusting a ratio between the number of well layers of the first color portion 60b and the number of well layers of the second color portion 60g, various white light from warm white to cool white may be implemented.

Meanwhile, the first barrier layer of the first color portion 60b may include a GaN layer, and other barrier layers may include an AlGaN layer. The GaN layer of the first barrier layer of the first color portion 60b may be doped with an n-type impurity, for example, Si, and a doping concentration may be within a range of, for example, 5E18/cm³ to 8E18/cm³. No intentional doping is performed on the other barrier layers. The first barrier layer may also include a hole blocking layer, which may be formed of the AlGaN layer. The hole blocking layer may be disposed at a boundary between a control portion 50 and the first color portion 60b. Meanwhile, the barrier layers disposed between the well layers of the first color portion 60b may be formed of the AlGaN layer. Specifically, each of the barrier layers may include an AlGaN capping layer and a high-temperature AlGaN barrier layer, and the AlGaN capping layer may have a band gap wider than the high-temperature AlGaN barrier layer. The AlGaN capping layer may be made thinner than the high-temperature AlGaN barrier layer. For example, the AlGaN capping layer may be formed to have a thickness of about 1nm and the high-temperature AlGaN barrier layer to have a thickness of about 35Å. The AlGaN capping layer is grown at a temperature lower than that for growing the high-temperature AlGaN barrier layer, and for example, it may be grown at a same temperature as a growth temperature of the well layer.

Meanwhile, the well layers 60b1 and 60b2 may be formed of InGaN or InAlGaN, and may have a composition that emits light in a blue region. The well layers may have a same composition, but the inventive concepts are not limited thereto, and the well layers may have different band gaps from one another.

The second color portion 60g is shown as having four sub-color portions 60g1, 60g2, 60g3, and 60g disposed between the first and last barrier layers, but the number of the sub-color portions 60g1, 60g2, and 60g3, and 60g4 is not limited thereto.

A first barrier layer of the second color portion 60g may be a GaN layer, and a last barrier layer may be an AlGaN layer. In addition, barrier layers disposed between the well layers may include an AlGaN capping layer, an Al(Ga)N layer, and a GaN layer. In the second color portion 60g, GaN layers of remaining barrier layers except for the last barrier layer may be doped with an n-type impurity, for example, Si. A doping concentration of Si doped in each of the barrier layers of the second color portion 60g may be lower than the doping concentration of Si doped in the first barrier layer of the first color portion 60b, and for example, it may be within a range of 5E17/cm³ to 1E18/cm³.

Meanwhile, a thickness of each of the well layers of the second color portion 60g may be substantially similar to a thickness of each of the well layers of the first color portion 60b, but the thickness of each of the barrier layers of the second color portion 60g may be greater than the thickness of each of the barrier layers of the first color portion 60b.

A resistor 70 may be disposed so as to prevent electrons from flowing into the second conductivity type semiconductor layer 80 without recombination. The resistor 70 may be formed of an AlGaN layer, and as shown in FIG. 10B, it may be a grading layer in which a composition of Al gradually increases.

In this embodiment, the second color portion 60g emitting green or yellow light is disposed adjacent to the second conductivity type semiconductor layer, and the first color portion 60g emitting blue light is disposed adjacent to the first conductivity type semiconductor layer. Through this, it is possible to provide a color device having improved visibility.

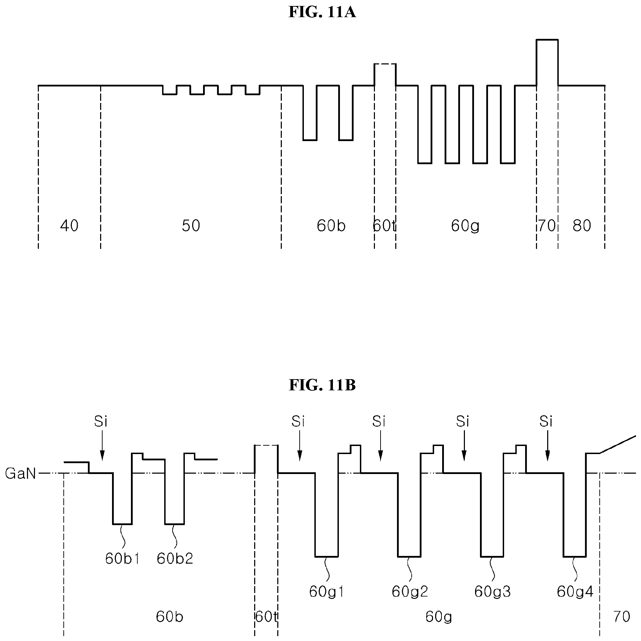

FIG. 11A is a schematic band diagram illustrating a color device according to another embodiment of the present disclosure, and FIG. 11B is a band diagram showing enlarged portions of a first color portion 60b and a second color portion 60g. In FIGs. 11A and 11B, only conduction bands are shown, and in FIG. 11B, a position of the conduction band of each layer is shown with respect to a conduction band of GaN.

Referring to FIGs. 11A and 11B, the color device according to this embodiment is substantially similar to the color device described with reference to FIGs. 10A and 10B, except that it includes an intermediate barrier layer 60t, that is, a tunnel barrier layer. The intermediate barrier layer 60t may be formed of an AlGaN layer, DBR, or the like. A band gap of the intermediate barrier layer 60t may be wider than that of the barrier layers of the first and second color portions 60b and 60g, without being limited thereto.

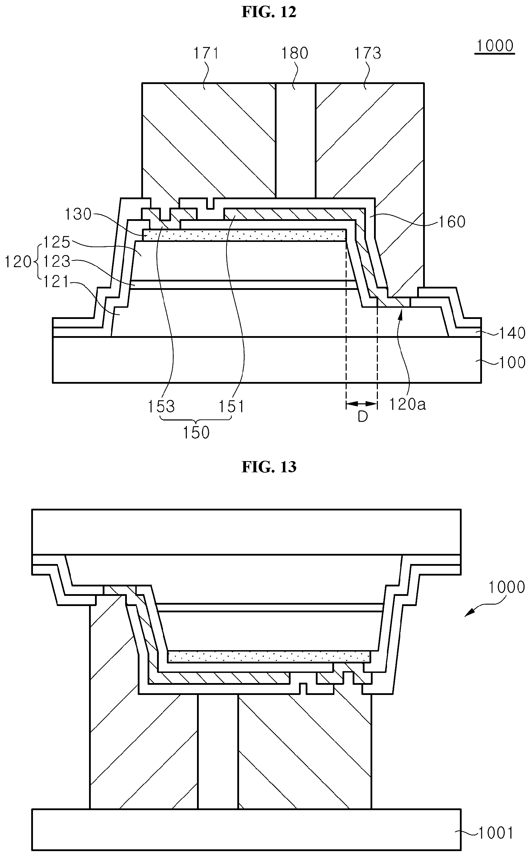

FIG. 12 is a schematic cross-sectional view illustrating a di-chromic device 1000 according to an embodiment of the present disclosure.

Referring to FIG. 12, the di-chromic device 1000 according to this embodiment is obtained by adding an electrode structure to the color device described in the previous embodiments. Specifically, the di-chromic device 1000 may include a base 100, a color device 120, an ohmic electrode 130, a first insulation layer 140, a pair of pad electrodes 150; 151, 153, a second insulation layer 160, bump electrodes 171 and 173, and a filling layer 180.

Since the base 100 is same as the base 10 described above, a detailed description thereof will be omitted to avoid redundancy. In addition, the color device 120 includes a first conductivity type semiconductor region 121, a color region 123, and a second conductivity type semiconductor region 125 same as the color devices of the above-described embodiments, and although not shown, it includes a control portion.

A portion of the first conductivity type semiconductor region 121 is exposed by etching the second conductivity type semiconductor region 125 and the color region 123. The exposed surface of the first conductivity type semiconductor region 121 becomes a first conductivity type contact region 120a. Meanwhile, an upper surface of the second conductivity type semiconductor region 125 may become a second conductivity type semiconductor contact region. The ohmic electrode 130 may be disposed on the second conductivity type semiconductor region 125 to provide an ohmic contact.

The ohmic electrode 130 may be formed of a metallic material (Al, Ti, Ni, Ag, Au, W, Sn, etc.) or a transparent conductive oxide (ITO, ZnO, AZO, IZO, etc.). The first insulation layer 140 may cover the ohmic electrode 130. The first insulation layer 140 may cover a portion of the ohmic electrode 130 and may cover a side surface of a mesa and a portion of the first conductivity type contact region 120a by a distance D. The first insulation layer 140 may include SiO2, SiNx, TiO2, Al2O3, and the like, and may include a distributed Bragg reflector. The first insulation layer 140 may also cover a side surface of the first conductivity type semiconductor region 121 and an upper surface of the base 100.

The portion of the ohmic electrode 130 and the portion of the first conductivity type contact region 120a may be exposed without being covered by the first insulation layer 140, and the pad electrodes 150; 151, 153 formed on the first insulation layer 140 may be electrically connected to the exposed ohmic electrode 130 and the second conductivity type contact region 120a.

The bump electrodes 171 and 173 are formed over the pad electrodes 150; 151, 153, and may include metallic materials such as Al, Ti, Ni, Ag, Au, W, Sn, and the like. The bump electrodes 171 and 173 may be electrically connected to the pad electrodes 150; 151, 153 to transfer electricity supplied from a circuit board to the color device 120.

The second insulation layer 160 may be further formed between the bump electrodes 171 and 173 and the pad electrodes 150;151, 153. The second insulation layer 160 may include SiO2, SiNx, TiO2, Al2O3, and a distributed Bragg reflector. Although the bump electrodes 171 and 173 are shown in FIG. 12 as being disposed in an upper region, the di-chromic device 1000 may be flip-mounted and electrically connected to the circuit board 1001 as shown in FIG. 13, and light may be emitted to the outside through the first conductivity type semiconductor region 121 and the base 100.

Meanwhile, the color region may be formed of a nitride semiconductor, and may emit light having peak wavelengths equal to or greater than the number of the pad electrodes 151 and 153.

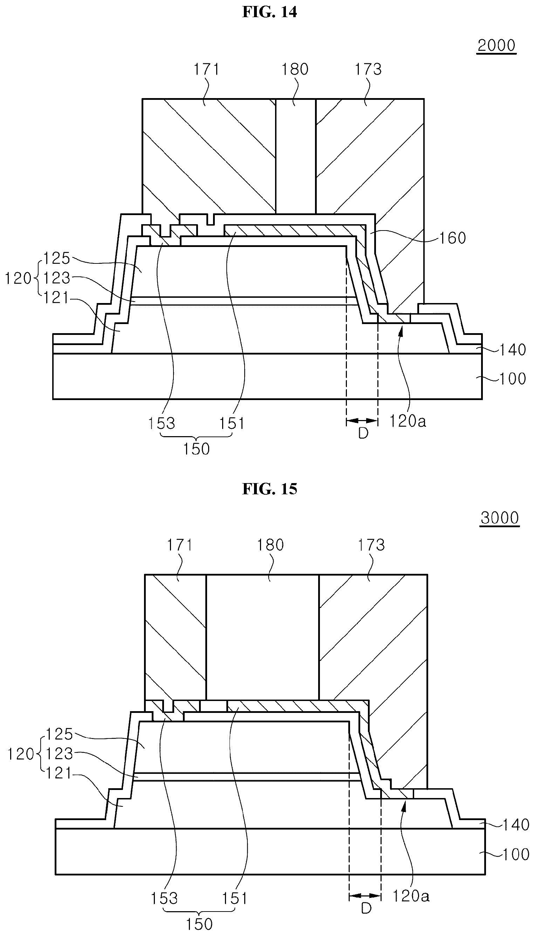

FIG. 14 is a schematic cross-sectional view illustrating a di-chromic device 2000 according to another embodiment of the present disclosure.

Referring to FIG. 14, the di-chromic device 2000 according to this embodiment is substantially similar to the di-chromic device 1000 described with reference to FIG. 12, except that the ohmic electrode 130 is omitted.

That is, in the di-chromic device 2000, an electrode pad 153 formed on the insulation layer 140 is in ohmic contact with the second conductivity type semiconductor region 125 without an additional ohmic electrode to serve as the ohmic electrode. The di-chromic device 2000 may also be flip-mounted on the circuit board 1001 as shown in FIG. 13.

FIG. 15 is a schematic cross-sectional view illustrating a di-chromic device 3000 according to another embodiment of the present disclosure.

Referring to FIG. 15, the di-chromic device 3000 according to this embodiment is substantially similar to the di-chromic device 2000 described with reference to FIG. 14, except that the second insulation layer 160 is omitted. The insulation layer 140 and the pad electrodes 150; 151, 153 may be disposed between the bump electrodes 171 and 173 and the color device 120, and the bump electrodes 171 and 173 may be directly formed on the pad electrodes 150; 151, 153. The di-chromic device 3000 may be flip-mounted on the circuit board 1001 as described with reference to FIG. 13, and light may be emitted to the outside through the first conductivity type semiconductor region 121 and the base 100.

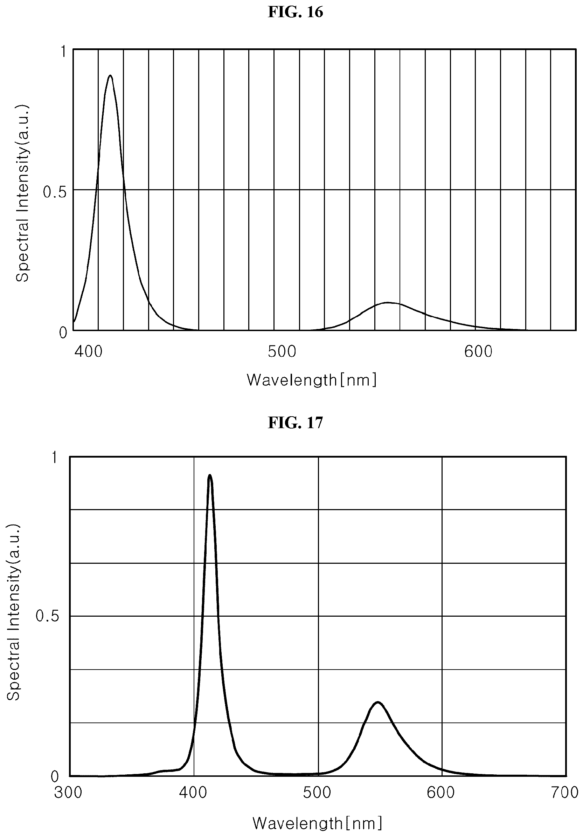

FIGs. 16 and 17 are graphs showing spectrums of color devices according to some embodiments of the present disclosure. An intensity of a peak in a blue region may be greater than an intensity of a peak in a longer wavelength region such as green, orange, red, or others, and desired visibility may be implemented by adjusting the intensity of light by adjusting a number or a thickness of a color portion.

In addition, the color device may implement color coordinates within a range of CIE color coordinate values (x=0.205 to 0.495, y=0.19 to 0.45).

Under a low current density condition of less than 35 mA/cm², an intensity of blue light may be 1.1 to 1.6 times that of green or yellow light. Meanwhile, under a high current density condition of 35 mA/cm² or more, the intensity of green or yellow light may be 0.25 to 0.8 times, specifically, 0.5 to 0.7 times of the intensity of blue light.

Referring to FIG. 17, a first peak may be within a range of 410nm to 435nm, and a second peak may be within a range of 535nm to 555nm.

Alternatively, an emission intensity of the second peak may be 0.45 to 0.75 times greater than an emission intensity of the first peak. Alternatively, an integrated area of the emission intensity of the first peak may be 0.3 to 0.75 times of an integrated area of the emission intensity of the second peak. Due to a difference in light emission intensities, it is possible to implement white light in a semiconductor itself. A spectral profile near the first peak may have an asymmetric shape with respect to a peak point thereof. Alternatively, a spectral profile near the second peak may have an asymmetrical shape with respect to a peak point thereof.

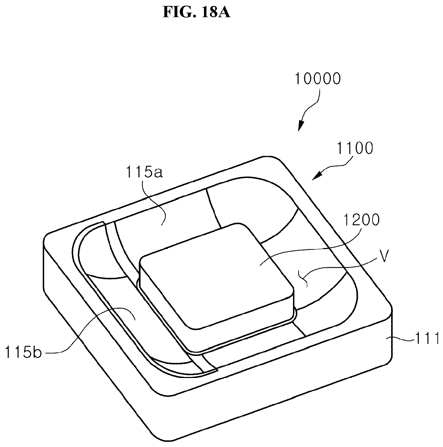

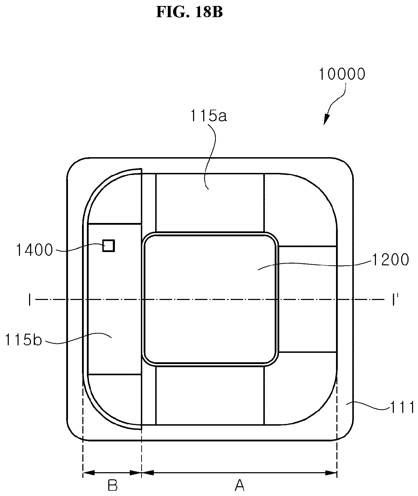

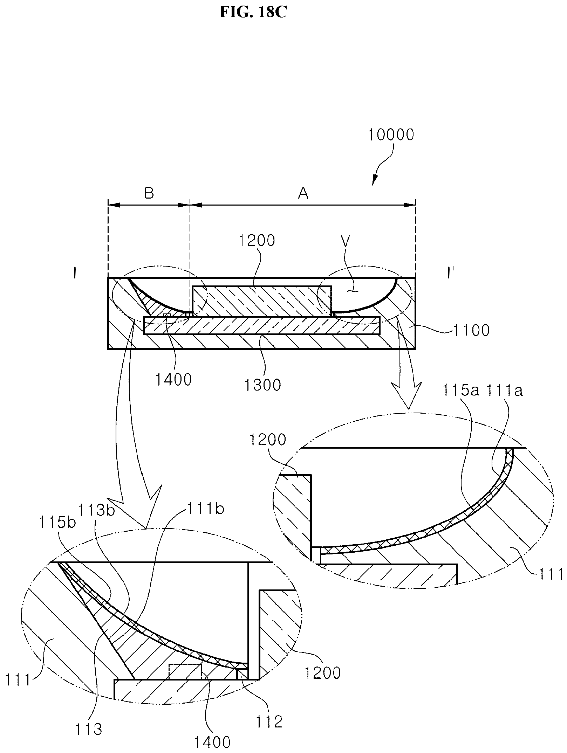

FIG. 18A is a perspective view illustrating a package to which a color device according to an embodiment of the present disclosure is applied, FIG. 18B is a plan view of FIG. 18A, and FIG. 18C is a cross-sectional view taken along line I-I' of FIG. 18B.

Referring to FIGs. 18A, 18B, and 18C, a package 10000 includes a housing 1100, a color device 1200, a lead frame 1300, and a Zener diode 1400.

The housing 1100 includes a body portion 111, a cover 113, and a coating portion 115 in this embodiment. As shown in the drawings, the body portion 111 may have a substantially rectangular shape in plan view, and may have a shape surrounding the lead frame 1300 so as to support the lead frame 1300. The housing 1100 may have a cavity V with one surface open therein, and the color device 1200 may be disposed in the cavity V.

Herein, a depth of the cavity V may be greater than a height of the color device 1200. In this case, as shown in FIGs. 18B and 18C, the body portion 111 may be divided into a region A and a region B. The region A may be a region where the color device 120 is mounted, and the region B may be a region where the Zener diode 140 is mounted.

Looking at the region A of the body portion 111, an inclined surface of the cavity V surrounding the color device 120 may have a surface that has a same slope with respect to the color device 120. In this case, a first body inclined surface 111a formed in the region A may be formed as a curved surface, as shown in FIG. 18C, and may be formed such that a slope of the curved surface becomes steeper toward an upper portion.

The first body inclined surface 111a formed in the region A is formed on each of three surfaces of the cavity V corresponding to three sides of the color device 1200 except for one side. In this case, an inner side of the first body inclined surface 111a may be disposed adjacent to a position where the color device 1200 is mounted. Accordingly, light emitted from the color device 1200 may be reflected from the first body inclined surface 111a and emitted toward the upper portion of the package 10000.

In this embodiment, a second body inclined surface 111b formed in the region B may be a linear cross-sectional shape. However, when the first body inclined surface 111a is formed as an inclined surface, the cross-sectional shape is not limited to being a linear cross-sectional shape, and may be formed as a curved cross-sectional shape.

In this case, as it can be seen in FIG. 18B, the region B may have a width in a vertical direction greater than a width in a vertical direction of the region A. Although this will be described later, this is to secure a space in which a cover 113 can be formed to cover the second body inclined surface 111b.

As shown in FIG. 18C, the cover 113 is disposed to cover the second body inclined surface 111b formed in the region B. The cover 113 is formed to have a thickness capable of covering the Zener diode 140 disposed in the region B, and is formed to a degree not to exceed a stepped portion 112. Also, as shown in the drawings, the cover 113 may have a cover inclined surface 113b formed as a gentle inclined surface. The cover inclined surface 113b may be formed as a curved surface, and may be formed such that a slope becomes gentle from an upper portion to a lower portion.

Herein, the cover 113 is described as being formed not to exceed the stepped portion 112, but is not limited thereto, and a portion of the cover 113 may be formed beyond the stepped portion 112 to a position where the light emitting diode chip 120 is mounted, if necessary. That is, the cover 113 may be formed to cover the second body inclined surface 111b and the Zener diode 1400 by using a viscous material including a reflective material. In this case, the reflective material may be TiO2 and Al2O3.

As the cover 113 is formed in the region B, the cover inclined surface 113b formed in the cavity V of the package 10000 may be formed in a shape similar to that of the first body inclined surface 111a. Accordingly, all surfaces of a reflection surface formed in the cavity V may be formed to be substantially same with respect to the color device 1200.

The coating portion 115 is formed to cover the first body inclined surface 111a and the cover inclined surface 113b by using a coating material including a reflective material. In this case, the reflective material may be TiO2 and Al2O3. That is, the coating portion 115 may be formed to cover all regions in the cavity V of the package 10000 except for the color device 120. To this end, the coating layer 115 may be formed on the first body inclined surface 111a and the cover inclined surface 113b by using various methods such as spraying, dispensing, jetting, film attaching, sputtering, e-beam deposition, and. the like, which may be performed above the cavity V of the package 10000, with an upper portion of the color device 1200 masked. Accordingly, a first coating inclined surface 115a may be formed in the region A of the cavity V of the package 10000, and a second coating inclined surface 115b may be formed in the region B.

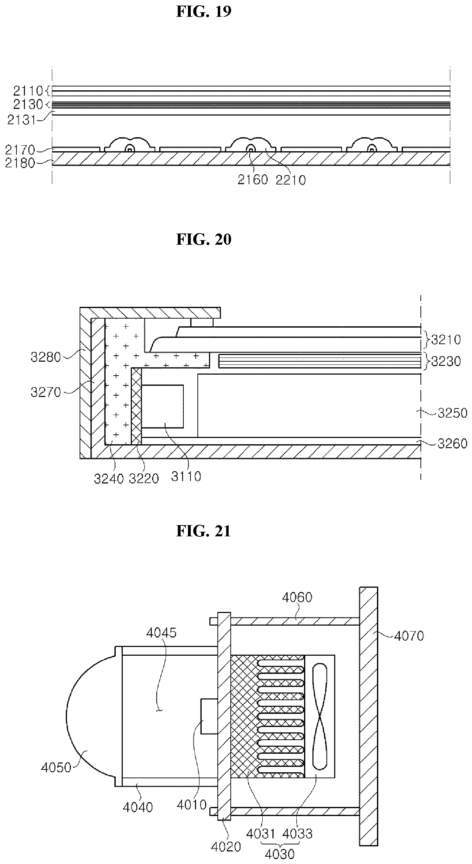

FIG. 19 is a cross-sectional view illustrating a display apparatus to which a color device according to an exemplary embodiment of the present disclosure is applied.

The display apparatus of this embodiment includes a display panel 2110, a backlight unit providing light to the display panel 2110, and a panel guide supporting a lower edge of the display panel 2110.

The display panel 2110 is not particularly limited, and may be, for example, a liquid crystal display panel including a liquid crystal layer. A gate driving PCB for supplying a driving signal to a gate line may be further disposed at the edge of the display panel 2110. Herein, the gate driving PCB may not be configured in an additional PCB, but may be formed on a thin film transistor substrate.

The backlight unit includes a light source module including at least one substrate and a plurality of light emitting devices 2160. Furthermore, the backlight unit may further include a base substrate 2180, a reflection unit 2170, a diffusion plate 213, and optical sheets 2130.

The base substrate 2180 may be opened upward and accommodate the substrate, the light emitting device 2160, the reflection sheet 2170, the diffusion plate 2131, and the optical sheets 2130. In addition, the base substrate 2180 may be coupled with the panel guide. The base substrate 2180 may be disposed under the reflection unit 2170, and the light emitting device 2160 may be disposed surrounded by the reflection unit 2170. However, without being limited thereto, the light emitting device 2160 may be disposed on the reflection unit 2170 when a reflective material is coated on a surface of the base substrate 2180. In addition, a plurality of substrates may be formed, and the plurality of substrates may be disposed in a form flush with one another but the inventive concepts are not limited thereto, and the backlight unit may include a single substrate.

The light emitting device 2160 may include the color device according to the above-described embodiments of the present disclosure. The light emitting devices 2160 may be regularly arranged in a predetermined pattern on the substrate. The light emitting devices 2160 may be arranged in a square shape, or in another form, may be staggered so as not to overlap adjacent light emitting devices 2160.

In addition, a light guide 2210 may be disposed on each of the light emitting devices 2160, thereby improving uniformity of light emitted from the plurality of light emitting devices 2160. The light guide 2210 may be one of materials such as Si, a lens, and a resin including a phosphor. The light guide 2210 may have an upper surface parallel to the base substrate 2180, or may have a convex curved surface.

The diffusion plate 2131 and the optical sheets 2130 are disposed on the light emitting device 2160. Light emitted from the light emitting device 2160 may be supplied to the display panel 2110 in a form of a surface light source via the diffusion plate 2131 and the optical sheets 2130.

As such, the light emitting device according to the embodiments of the present disclosure may be applied to a direct-type display apparatus as the present embodiment.

FIG. 20 is a cross-sectional view illustrating a display apparatus to which a color device according to another embodiment of the present disclosure is applied.

The display apparatus having a backlight unit according to this embodiment includes a display panel 3210 on which an image is displayed, and a backlight unit disposed on a rear surface of the display panel 3210 to emit light. Furthermore, the display apparatus includes a frame 3240 supporting the display panel 3210 and accommodating the backlight unit, and covers 3270 and 3280 surrounding the display panel 3210.

The display panel 3210 is not particularly limited, and may be, for example, a liquid crystal display panel including a liquid crystal layer. A gate driving PCB for supplying a driving signal to a gate line may be further disposed at an edge of the display panel 3210. Herein, the gate driving PCB may not be configured in an additional PCB, but may be formed on a thin film transistor substrate. The display panel 3210 is secured by the covers 3270 and 3280 disposed under and over the display panel 3210, and the cover 3270 disposed under the display panel 3210 may be coupled to the backlight unit.

The backlight unit providing light to the display panel 3210 includes a lower cover 3270 having a partially opened upper surface, a light source module disposed on an inner side of the lower cover 3270, and a light guide plate 3250 disposed in parallel with the light source module to convert point light into surface light. In addition, the backlight unit of this embodiment may further include optical sheets 3230 disposed on the light guide plate 3250 to diffuse and condense light, and a reflection sheet 3260 disposed under the light guide plate 3250 to reflect light proceeding in a lower direction of the light guide plate 3250 toward the display panel 3210.

The light source module includes a substrate 3220 and a plurality of light emitting devices 3110 disposed apart from one another at regular intervals on one surface of the substrate 3220. The substrate 3220 is not limited as long as it supports the light emitting device 3110 and is electrically connected to the light emitting device 3110, and may be, for example, a printed circuit board. The light emitting device 3110 may include at least one color device according to the above-described embodiments of the present disclosure. Light emitted from the light source module is incident on the light guide plate 3250 and supplied to the display panel 3210 through the optical sheets 3230. Through the light guide plate 3250 and the optical sheets 3230, a point light source emitted from the light emitting devices 3110 may be transformed into a surface light source.

As such, the color device according to the embodiments of the present disclosure may be applied to an edge-type display apparatus as the present embodiment.

FIG. 21 is a cross-sectional view illustrating an example in which a color device according to another embodiment of the present disclosure is applied to a lighting apparatus.

Referring to FIG. 21, the lighting apparatus includes a lamp body 4070, a substrate 4020, a light emitting device 4010, and a cover lens 4050. Furthermore, the lighting apparatus may further include a heat dissipation unit 4030, a support rack 4060, and a connection member 4040.

The substrate 4020 is secured by the support rack 4060 and disposed apart over the lamp body 4070. The substrate 4020 is not limited as long as it can support the light emitting device 4010, and may be, for example, a substrate having a conductive pattern such as a printed circuit board. The light emitting device 4010 may be disposed on the substrate 4020, and supported and secured by the substrate 4020. In addition, the light emitting device 4010 may be electrically connected to an external power source through the conductive pattern of the substrate 4020. In addition, the light emitting device 4010 may include at least one color device according to the above-described embodiments of the present disclosure.

The cover lens 4050 is disposed on a path along which light emitted from the light emitting device 4010 moves. For example, as shown in the drawings, the cover lens 4050 may be disposed apart from the light emitting device 4010 by the connection member 4040, and disposed in a direction in which light emitted from the light emitting device 4010 is to be provided. A viewing angle and/or color of light emitted from the lighting apparatus to the outside may be adjusted by the cover lens 4050. Meanwhile, the connection member 4040 secures the cover lens 4050 to the substrate 4020, and may serve as a light guide by being disposed to surround the light emitting device 4010 and providing a light emitting path 4045. In this case, the connection member 4040 may be formed of a light reflective material or coated with a light reflective material. Meanwhile, the heat dissipation unit 4030 may include a heat dissipation fin 4031 and/or a heat dissipation fan 4033, and may emit heat generated when the light emitting device 4010 is driven to the outside, but is not limited thereto, and it may not include a component related to heat dissipation.

As such, the color device according to the embodiments of the present disclosure may be applied to a lighting apparatus or a headlamp for a vehicle as in the present embodiment.

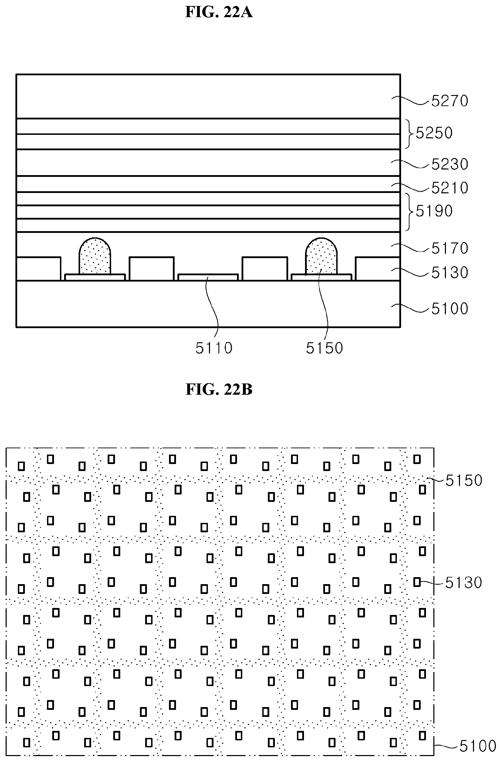

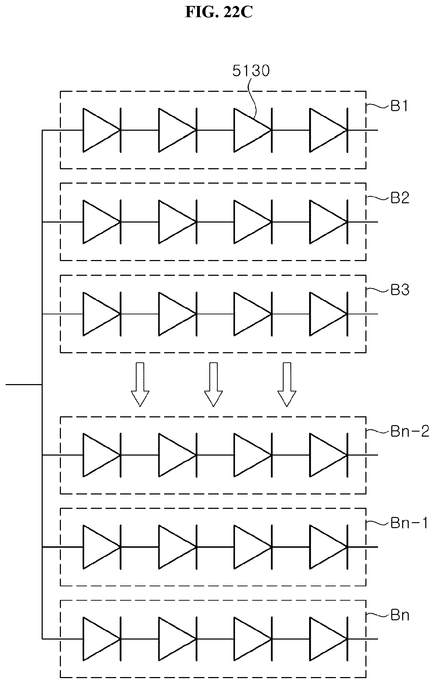

FIGs. 22A, 22B, and 22C are a schematic cross-sectional view, a plan view, and a circuit diagram illustrating a display apparatus to which a color device according to another embodiment of the present disclosure is applied, respectively. FIG. 22A is a partial cross-sectional view of the display apparatus, FIG. 22B is a plan view of a backlight unit, and FIG. 22C is a circuit diagram of the backlight unit.

Referring to FIGs. 22A, 22B, and 22C, the display apparatus of this embodiment includes a display panel 5270 and a backlight unit providing light to the display panel 5270.

The display panel 5270 is not particularly limited, and may be, for example, a liquid crystal display panel including a liquid crystal layer. A gate driving PCB for supplying a driving signal to a gate line may be further disposed at an edge of the display panel 5270. Herein, the gate driving PCB may not be configured in an additional PCB, but may be formed on a thin film transistor substrate.

The backlight unit may include a circuit board 5100, a reflection unit 5110, a light emitting device 5130, a dam portion 5150, a molding member 5170, a diffusion film 5190, and a blue light transmittance (BLT) film, a quantum dot (QD) film 5230, and a brightness enhancement film 5250.

The backlight unit includes a circuit board 5100 and a light source module including a plurality of light emitting devices 5130 disposed on the circuit board 5100. One light source module may be used as the backlight unit, or a plurality of light source modules may be arranged on a plane and used as the backlight unit.

The reflection unit 5110 may be disposed on a surface of the circuit board 5100, as shown in FIG. 22A. The reflection unit 5110 may be provided as a reflection sheet or coated on the circuit board 5100. The reflection unit 5110 may surround the light emitting devices 5130 by being formed around a region where the light emitting devices 5130 are mounted. However, the inventive concepts are not limited thereto, and the light emitting devices 5130 may be disposed on the reflection unit 5110.

The circuit board 5100 has circuits for supplying power to the light emitting devices 5130. The light emitting devices 5130 may be connected in series, parallel, or series-parallel through circuits formed on the circuit board 5100. An electrical connection structure of the light emitting devices 5130 will be described later with reference to FIG. 22C.

The light emitting device 5130 includes at least one color device of the present disclosure described above, and a detailed description thereof will be omitted.

The dam portion 5150 is formed on the circuit board 5100. The dam portion 5150 divides a region on the circuit board 5100 into a plurality of blocks, as shown in FIG. 23B. The plurality of light emitting devices 5130 may be disposed in each of the blocks. For example, in this embodiment, four light emitting devices 5130 are disposed in each of the blocks. However, the inventive concepts are not limited thereto, and more or fewer light emitting devices 5130 than four may be disposed in each of the blocks.

The dam portion 5150 may include a reflective material that reflects light generated by the light emitting devices 5130, and may be formed of, for example, white silicone.

The molding member 5170 fills the blocks partitioned by the dam portion 5150. The molding member 5170 may be formed of transparent silicone. The dam portion 5150 and the molding member 5170 may include silicone of a same series, and may be formed of, for example, phenyl or methyl-based. Since the dam portion 5150 and the molding member 5170 include the same type of silicone, bonding force between the molding member 5170 and the dam portion 5150 may be improved.

The diffusion film 5190 is disposed on the molding member 5170. The diffusion film 5190 diffuses light generated by the light emitting devices 5130 to evenly diffuse light. The diffusion film 5190 may adhere to the molding member 5170, but is not limited thereto, and may be spaced apart from the molding member 5170. The diffusion film 5190 may be composed of one sheet, or may be composed of a plurality of sheets as shown in FIG. 22A.

The BLT film 5210 and the QD film 5230 may be disposed on the diffusion film 5190. The QD film 5230 includes quantum dots that convert light emitted from the light emitting devices 5130, for example, blue light into green light and red light.

The BLT film 5210 transmits light emitted from the light emitting devices 5130, such as blue light, and reflects green light and red light generated from the QD film 5230. Accordingly, it is possible to prevent green light and red light generated from the QD film 5230 from being lost while proceeding toward the circuit board 5100.

Meanwhile, the brightness enhancement film 5250 is disposed on the QD film 5230 to improve brightness of light proceeding to the display panel 5270. The brightness enhancement film 5250 may include lower and upper brightness enhancement films, and may further include a dual brightness enhancement film (DBEF).

As shown in FIG. 22B, the light emitting devices 5130 are disposed in blocks partitioned by the dam portion 5150. The light emitting devices 5130 in a same block may be spaced apart from one another at equal intervals. In addition, the light emitting devices 5130 in adjacent blocks may also be spaced apart at similar intervals. As shown in FIG. 22B, the light emitting devices in one block may be disposed in a tilted shape with respect to a rectangular block.

Meanwhile, as shown in FIG. 22C, the light emitting devices 5130 arranged in each block B1 through Bn may be serially connected to one another. In addition, anodes of the light emitting devices in a first to nth blocks may be connected to one another, and cathodes may be spaced apart from one another. For example, anodes of the light emitting devices in a first block B1 and anodes of the light emitting devices in a second block B2 are connected to one another, and cathodes of the light emitting devices in the first block B1 and cathodes of the light emitting devices in the second block B2 are electrically spaced apart from one another. Accordingly, the light emitting devices 5130 may be independently driven in block units.

According to this embodiment, as the light emitting devices 5130 are independently driven in block units, for example, a black region may be implemented by turning off the light emitting devices 5130. Accordingly, contrast may be implemented more clearly, and power consumption may be reduced compared to a conventional LCD display in which the backlight source is always turned on. Furthermore, by using the QD film, vivid colors may be implemented.

As such, the color device according to the embodiments of the present disclosure may be applied to a mini LED display apparatus as the present embodiment.

Although some exemplary embodiments have been described above, it should be understood that these embodiments are provided for illustration only and are not to be construed in any way as limiting the present disclosure. It should be understood that features or components of one exemplary embodiment can also be applied to other exemplary embodiments without departing from the spirit and scope of the present disclosure.

## Claims

1. A di-chromic device, comprising:
a base;
a first conductivity type semiconductor region disposed on the base;
a control portion disposed on the first conductivity type semiconductor region;
a color region formed on the control portion; and
a second conductivity type semiconductor region disposed on the base, wherein:
the control portion is configured to relieve strain in the color region, and
the color region includes a first color portion and a second color portion, and the first color portion includes a color material having a different composition than that of the second color portion.

2. The di-chromic device of claim 1, wherein:
the first color portion generates blue light,
the second color portion generates green or yellow light, and
the di-chromic device implements white light by a combination of blue light from the first color portion and green or yellow light from the second color portion.

3. The di-chromic device of claim 1, wherein:
each of the first color portion and the second color portion includes a plurality of sub-color portions, and
the number of sub-color portions in the first color portion is greater than the number of sub-color portions in the second color portion.

4. The di-chromic device of claim 3,
wherein the number of sub-color portions in the first color portion is 2 to 7 times of the number of sub-color portions in the second color portion.

5. The di-chromic device of claim 4,
wherein the di-chromic device emits white light under a current density within a range of 1.75A/cm² or more and less than 35A/cm².

6. The di-chromic device of claim 1, wherein:
each of the first color portion and the second color portion includes a plurality of sub-color portions, and
the number of sub-color portions in the second color portion is equal to or greater than the number of sub-color portions in the first color portion.

7. The di-chromic device of claim 6,
wherein the number of sub-color portions in the second color portion is 1 to 4 times of the number of sub-color portions in the first color portion.

8. The di-chromic device of claim 7,
wherein the di-chromic device emits white light under a current density within a range of 35A/cm² or more and 140A/cm² or less.

9. The di-chromic device of claim 1, further comprising:
pad electrodes electrically connected to the first conductivity type semiconductor region and the second conductivity type semiconductor region, respectively.

10. The di-chromic device of claim 9,
wherein the color region is formed of a nitride semiconductor, and emits light having peak wavelengths equal to or greater than the number of the pad electrodes.

11. The di-chromic device of claim 9, further comprising:
bump electrodes electrically connected to the pad electrodes, respectively.

12. The di-chromic device of claim 1, further comprising:
a tunnel barrier layer between the first color portion and the second color portion.

13. The di-chromic device of claim 12,
wherein the tunnel barrier layer includes an AlGaN layer or DBR.

14. The di-chromic device of claim 1, wherein:
each of the first and second color portions includes a plurality of barrier layers and a plurality of well layers disposed between the barrier layers,
the well layers of the first color portion have a band gap wider than the well layers of the second color portion, and
the first color portion is closer to the first conductivity type semiconductor region than the second color portion.

15. The di-chromic device of claim 14,
wherein among the barrier layers of the first color portion, a first barrier layer closest to the first conductivity type semiconductor region includes a GaN layer doped with Si, and remaining barrier layers do not include an intentionally doped layer.

16. The di-chromic device of claim 15,
wherein among the barrier layers of the first color portion, the remaining barrier layers are formed of an AlGaN layer.

17. The di-chromic device of claim 14,
wherein among the barrier layers of the second color portion, barrier layers excluding a last barrier layer include a GaN layer doped with Si, and the last barrier layer includes an AlGaN layer without intentional doping.

18. The di-chromic device of claim 17,
wherein a first barrier layer of the second color portion is formed of a GaN layer, and barrier layers disposed between the well layers of the second color portion includes an AlGaN capping layer, an Al(Ga)N layer having a band gap wider than the AlGaN capping layer, and a GaN layer.

19. The di-chromic device of claim 1,
wherein the control portion includes a holder generating a spot.

20. The di-chromic device of claim 19,
wherein the color region includes an extension extending toward the spot in a V shape.
